Europäisches Patentamt

European Patent Office

Office européen des brevets

(11) Publication number: **0 042 272**
**B1**

# EUROPEAN PATENT SPECIFICATION

(45) Date of publication of patent specification: **28.08.85**

(51) Int. Cl.⁴: **H 03 C 1/62, H 04 B 1/04, H 03 F 3/24**

(21) Application number: **81302632.5**

(22) Date of filing: **12.06.81**

(54) A pulse width modulation system.

(30) Priority: **18.06.80 GB 8019963**

(43) Date of publication of application:
**23.12.81 Bulletin 81/51**

(45) Publication of the grant of the patent:
**28.08.85 Bulletin 85/35**

(84) Designated Contracting States:
**CH DE FR IT LI NL SE**

(56) References cited:
**EP-A-0 042 264**
**DE-A-1 766 586**
**DE-A-2 741 038**
**DE-A-2 821 683**
**DE-B-1 218 557**
**DE-B-2 715 133**
**GB-A-1 556 653**
**US-A-4 118 677**
**US-A-4 140 980**

(73) Proprietor: **THE MARCONI COMPANY LIMITED**
**Marconi House New Street**
**Chelmsford Essex CM1 1PL (GB)**

(72) Inventor: **Molyneux-Berry, Robert Bewes**
**12, Hopping Jacks Lane**
**Danbury Essex (GB)**
Inventor: **Brett, John Edward**
**1, Roland Close**
**Broomfield Chelmsford Essex, CM1 5ED (GB)**

(74) Representative: **Tolfree, Roger**
**The Marconi Company Limited Marconi House**
**New Street**
**Chelmsford, CM1 1PL (GB)**

## Description

This invention relates to a pulse width modulation (P.W.M.) system, and particularly to such a system when employed to apply amplitude modulation to the R.F. stage of a radio transmitter.

Such systems employ a pulse width amplifier to amplify the incoming radio signals so that their maximum peak to peak voltage is 2V where V is the audio voltage applied to R.F. stage when audio modulation is not present. The amplified audio signal is therefore able to modulate the supply voltage applied to the R.F. stage between 0 and 2V volts.

A conventional pulse width amplifier when used for tha above purpose would convert the incoming audio signal to P.W.M. form in such a way that the length of each pulse is equal to the pulse repetition period at maximum amplitude values of the incoming signal and so that the length of each pulse is zero at minimum amplitude values. This leads to distortion when the pulses are reconverted after amplification to amplitude modulated form.

The obvious way of overcoming this problem is to attenuate the incoming audio signal so that its amplitude is never sufficient to produce pulses of zero duration or of a duration equal to the pulse repetition period. However, this leads to less than 100% modulation of the carrier. A further reason why 100% modulation might not be obtained is that the switches 13 and 14 do not have zero resistance when switched on.

Efforts have been made in the past to solve this problem for example as described with reference to Fig. 5 in German Patent Specification 1218557, but have involved the use of auto transformers or tapped chokes or other inductive components having consistent characteristics over a required audio frequency band. Such components, have to handle a very large power and the need for their inclusion can introduce considerable problems of design and reliability.

This invention provides a circuit for using an input signal to modulate the current supplied to a load comprising: means for providing a first voltage source for supplying current to the load; a pulse width encoder connected to receive the input signal; means for providing a second voltage exceeding the voltage of the first voltage source; amplifying means comprising two switches connected in series with the means for providing the second voltage, means for operating the switches in anti-phase in response to output pulses of the pulse width encoder and smoothing means connected to a point between the switches to produce an amplified version of the input signal, characterised in that the second voltage exceeds twice the first voltage and in that a D.C. blocking capacitor couples the amplified signal at the output of the smoothing means to the load so as to modulate the current supplied thereto.

By using a second voltage which exceeds (by δV) twice the first voltage (V) it is possible to obtain 100% modulation without using pulse widths approaching zero or approaching the pulse repetition period. Under unmodulated conditions the D.C. levels at either side of the blocking capacitor are different and the capacitor prevents circulation currents arising from this potential difference. When modulation is present the capacitor enables the voltage on the load to swing symmetrically about V, rather than V+δV/2.

The voltage sources are preferably separate: i.e. they are designed so that variations in current drawn from either one do not substantially affect the other. However this feature, which is the subject of our co-pending european application 0042264, is not essential to the invention and it would be possible for one, lower, voltage source to be provided by a suitable tapping on the other, higher, voltage source.

One way in which the invention may be performed will now be described by way of example with reference to the accompanying schematic drawings in which:—

Figure 1 illustrates a circuit constructed in accordance with the invention and

Figure 2 shows various waveforms which appear at different parts of the circuit shown in Figure 1.

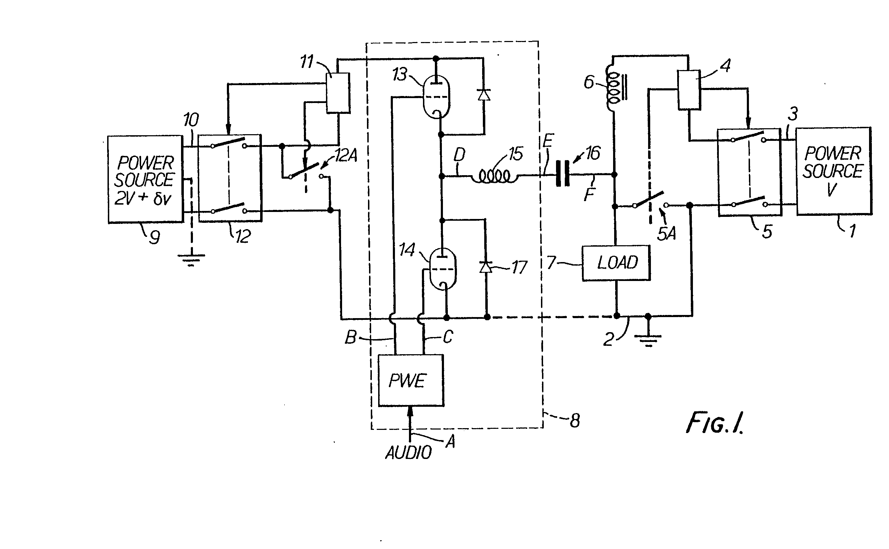

Referring firstly to Figure 1, a first voltage source 1 has one output line connected to a grounded conductor 2 and another output line 3 to which it applies a rectified voltage V. The current through the line 3 is monitored by a current sensing device 4 which provides a control signal when the current exceeds a safe value. Additional conventional sensing devices may be fitted to other parts of the circuit to provide a like control signal in the event of other types of fault. The control signal is operative to open contacts of a circuit breaker 5 and, in the particular systems illustrated, to close contacts 5A. The components 4, 5 and 5A are collectively termed a "protection device". The voltage source 1 is responsible for the production of a steady current which passes through an audio-blocking inductor 6 and a load 7 and provides power from which an R.F. carrier signal is derived.

The load 7 is the R.F. valve of a radio transmitter the anode of which, for correct operation under unmodulated carrier conditions, needs to be maintained at a voltage of V volts, this requirement being met by the power source 1.

The transmitter is amplitude modulated by superimposing an audio voltage on the anode of the R.F. valve i.e. at point F on Figure 1. The most efficient and effective degree of modulation is obtained when the maximum (i.e. loudest) audio signal to be handled by the transmitter has a peak-to-peak amplitude of 2V at the R.F. valve anode, i.e. the potential of point F varies, in accordance with the audio signal, between zero volts (ground potential) and peaks of 2V. This is termed 100% amplitude modulation. It is normally important in broadcasting transmitters to avoid or minimise audio distortion.

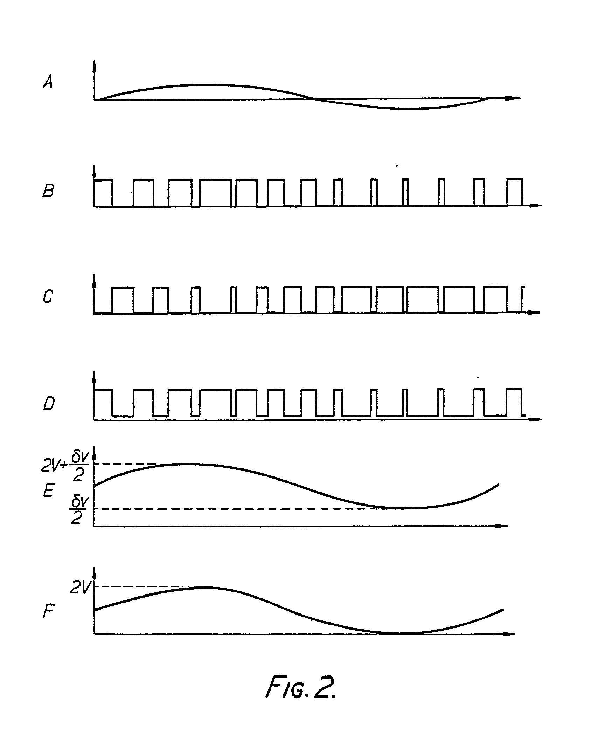

The anode voltage is modulated by an audio signal which is introduced at point A shown on Figure 1, this signal being represented diagrammatically at A on Figure 2. The signal A is amplified by a pulse width modulation amplifier 8 which is supplied with power from a second voltage source 9 which is notably not connected to the first voltage source by a direct current discharge path. This voltage source 9 has, in the illustrated circuit, one output line connected to the grounded conductor 2 and maintains a rectified voltage of $2V+\delta V$ on its other output line 10. Positioned in line 10 is a current sensor 11 which, when it senses a current in excess of that which, can safely be delivered by the source 9 or which can safely be passed by switches 13 and 14, to be described later, produces a control signal which operates a fast acting circuit breaker 12 and even faster acting switch 12A. A like control signal may be produced by one or more additional conventional fault sensing devices elsewhere in the circuit. The components 11, 12 and 12A in combination constitute a second protection device. However, unlike the protection device 4, 5 and 5A which can be relatively slow to respond to excessive currents, because the inductor 6 limits the rate of rise of current; the protection device 11, 12 and 12A needs to be able to respond very quickly. It is notable however that this second protection device does not handle all the power delivered to the load since most of this is supplied from power source 1. Because it does not handle all the power, the device 11, 12 and 12A can be designed to operate reliably with much less difficulty than if it had needed to handle the whole power consumed by the load.

The pulse width modulation amplifier 8 will now be described. The input signal A is shown in Figure 2 and is composed of parts where its voltage exceeds zero and parts where its voltage is below zero. The waveform A is converted by the pulse width encoder P.W.E., whose construction may be of a known type, into a series of pulses B (Figures 1 and 2) the width of each pulse depending on the instantaneous voltage level of A. Thus the pulse length is a minimum at times coincident with troughs in the waveform A; and the pulse width is at a maximum at times when the waveform A is at a positive peak. When the waveform A is at zero the pulse length at B is approximately half the duration of the spaces between pulses. In this particular pulse width encoder the maximum pulse width is little less than the pulse repetition period to avoid distortion which would otherwise occur if the pulses are not perfectly shaped. Similarly, the minimum pulse width is greater than zero, also for the purpose of avoiding distortion.

In the illustrated system the pulse width encoder P.W.E. also produces an output C which is the inverse of output B. The signals B and C are used to switch valves 13 and 14 in such a way that, when waveform B is at a high level, the valve 13 is switched on; and, when C is at a high level, the valve 14 is switched on. When the valve 13 is switched on it has very low resistance and so the point D is a little less than $2V+\delta V$ volts as supplied by the power source 9. At other times, when the valve 14 is switched on, the point D is a little above zero volts because it is effectively switched to the earthed line 2. The voltage at point D therefore fluctuates between just below $2V+\delta V$ volts and just above zero volts as shown at D on Figure 2. This follows the waveform of B. The *average* voltage at D therefore follows the waveform A but is greatly amplified.

In the alternative embodiment (not illustrated) only the signal C is generated by the pulse width encoder, and applied to valve 14 as in Figure 1. The grid control circuit of valve 13 is connected to the anode of valve 14 in such a way that the two valves 13 and 14 conduct in anti-phase. There are several known methods of performing this.

An energy store in the form of an indicator 15 is used to provide a voltage E whose value represents the short term average voltage at D. Further energy storage components, of conventional type, may be added to improve the degree to which the pulses are filtered out. With no audio signal at A the D.C. voltage at E is in excess of the voltage V by approximately $\delta V/2$ but no D.C. current flows through inductor 15, current being prevented by capacitor 16. Where an audio signal of maximum modulation is applied at A the voltage E varies between about $\delta V/2$ and $2V+\delta V/2$ in response to variations in the average voltage at D. Thus the variation in voltage E can equal $2V$ even though 100% pulse width modulation (with its associated distortion) has not been employed. The $2V$ voltage variation at E is applied to the load 7 through the capacitor 16, thus modulating the load voltage between 0 and $2V$ as shown at F.

In the circuit shown in Figure 1 the first voltage source 1 is required to supply a steady current to the load 7. However, this is not essential and the invention is applicable to systems having a controlled carrier level.

In another modification the amplifier 8 is not connected to the earthed conductor 2, the part of the line 2 shown in broken lines being omitted. Instead, the line 10 may be earthed or an earth connection may be made to a centre tap on the voltage source 9, also as shown in broken lines. An advantage of such a centre tap is that the maximum voltage between earth and either output of the voltage source is just a little over V volts instead of over $2V$ volts.

**Claim**

A circuit for using an input signal (A) to modulate the current supplied to a load (7) comprising: means for providing a first voltage source (1) for supplying current to the load; a pulse width encoder (PWE) connected to receive the input signal (A); means (9) for providing a second voltage exceeding the voltage of the first voltage source; amplifying means comprising two switches (13, 14) connected in series with the means (9) for providing the second voltage, means for operating the switches in anti-phase in response to output pulses (B, C) of the pulse width encoder, and smoothing means (15) connected to a point (D) between the switches (13, 14) to produce an amplified version (E) of the input signal (A), characterised in that the second voltage exceeds twice the first voltage and in that a D.C. blocking capacitor (16) couples the amplified signal (E) at the output of the smoothing means (16) to the load (7) so as to modulate the current supplied thereto.

**Revendication**

Un circuit permettant d'utiliser un signal d'entrée (A) pour moduler le courant appliqué sur une charge (7) et comprenant: un dispositif constituant une première source de tension (1) pour fournir le courant à la charge; un codeur de durée des impulsions (P.W.E.) raccordé pour recevoir le signal d'entrée (A); un dispositif (9) constituant une seconde source de tension qui dépasse la tension de la première source; un dispositif d'amplification comprenant deux commutateurs (13, 14) raccordés en série avec le dispositif (9) pour fournir la seconde tension, un dispositif pour faire fonctionner les commutateurs à tube en opposition de phase en réponse aux impulsions de sortie (B, C) du codeur de durée des impulsions et un dispositif de lissage (15) raccordé sur un point situé entre les commutateurs (13, 14) pour produire une version amplifiée (E) du signal d'entrée; celle-ci se caractérise par la seconde tension qui dépasse de deux fois la première tension et par un condensateur de blocage C.C. (16) qui couple le signal amplifié (E) sur la sortie du dispositif de lissage à la charge (7) afin de moduler le courant fourni mentionné auparavant.

**Patentanspruch**

Eine Schaltung zur Anwendung eines Eingangssignals (A) zum Aussteuern des zu einer Bürde (7) gelieferten Stroms bestehend aus: einer Einrichtung zum Erstellen einer ersten Spannungsquelle (1) welche Strom an die Bürde liefert; einem Impulsbreitencodierer (PWE), der zum Empfangen des Eingangssignals (A) angeschlossen ist; Einrichtungen (9) zum Erstellen einer zweiten Spannung, die die Spannung der ersten Spannungsquelle übersteigt; Verstärkungseinrichtungen, die aus zwei Schaltern (13, 14) bestehen, die in Reihe mit der Einrichtung (9) zum Erstellen der zweiten Spannung geschaltet sind; Einrichtung zum gegenphasigen Betätigen der Schalter auf Ansprechen auf Ausgangsimpulse (B, C) des Impulsbreitencodierers und Glättungsmittel (15), die an einem Punkt (D) zwischen den Schaltern (13, 14) angeschlossen sind, um eine verstärkte Ausführung (E) des Eingangssignals (A) zu erstellen, dadurch gekennzeichnet, daß die zweite Spannung den doppelten Wert der ersten Spannung übersteigt und daß ein Gleichstrom-Sperrkondensator (16) das verstärkte Signal (E) am Ausgang der Glättungsmittel (15) an die Bürde (7) anschließt, um auf diese Weise den daran gelieferten Strom zu modulieren.

Fig.1.

A

B

C

D

$2V+\dfrac{\delta v}{2}$

E

$\dfrac{\delta v}{2}$

$2V$

F

FIG. 2.